# EUROPEAN PATENT APPLICATION

(11) **EP 2 908 048 A1**
(43) Date of publication of application: **19.08.2015**
(21) Application number: 14155245.5
(22) Date of filing: 14.02.2014
(51) Int. Cl.: F21V 8/00, G02F 1/1335, G02B 19/00, H01L 33/52, H01L 33/58, H01L 33/60, F21K 99/00, F21V 5/04, F21V 13/04, G02B 3/04, G02B 27/09, G02B 5/08, G02B 5/126, G02B 5/02

(54) **LED-backlight for liquid crystal display**

(71) Applicant: Tongfang Global Limited, Shenzhen City Guangdong (CN); Shenyang Tongfang Multimedia Technology Co., Ltd., Shenyang City Liaoning (CN)
(72) Inventor: Lam, Th, Shenzhen City, Guangdong (CN); Lu, Wen-Sheng, Shenzhen City, Guangdong (CN); Huang, Chih-Ming, Shenzhen City, Guangdong (CN); Chuang, Tsung-Hsien, Shenzhen City, Guangdong (CN); Ng, Christopher, Shenzhen City, Guangdong (CN)
(74) Representative: Jeannet, Olivier

(57) **Abstract**

The invention relates to a LED display device. Primarily, it comprises a liquid crystal display (1), a shell (2), a plurality of lighting modules (3) and two reflective layers (4). The present invention is a liquid crystal display device which uses the light emitting diode (31) to combine with polymethylmethacrylate (PMMA) as a lighting module (3). The secondary lens theory composed of different refractive index between air and PMMA and the angle of the reflective layers (4) on the inner surface of the side planes (22) are used to effectively increase the refracted angle of light emitted from the light emitting diode (31) and the distance of the mixed light and to effectively reach the advantages of thinner liquid crystal display and lower power consumption.

## Description

### BACKGROUND OF THE INVENTION

### 1. Fields of the invention

The present invention relates to a LED display device, especially to a liquid crystal display device which uses the light emitting diodes to combine with polymethylmethacrylate (PMMA) as a lighting module. The secondary lens theory composed of different refractive index between air and PMMA and the angle of the reflective layers on the inner surface of the side planes are used to effectively increase the refracted angle of light emitted from the light emitting diode and the distance of the mixed light and to effectively reach the advantages of thinner liquid crystal display and lower power consumption.

### 2. Descriptions of Related Art

With the advancements in the manufacturing industry of the semiconductor and liquid crystal display, the liquid crystal displays have the advantages of the small size, light weight, and low power consumption, and they have been widely used in the most advanced electronic products of the family televisions, computer display screens, digital cameras, projectors, and mobile phones to replace completely the traditional screens with a cathode ray tube. Since the liquid crystal cannot luminescence by itself, so the backlight module can supply enough brightness and uniform light source, so that the liquid crystal display can normally show images. In recent years, the application ranges of the liquid crystal display extend and continue to grow, and combine with the strong demands of big screens from notebooks, monitors, LCD TVs, and smart phones, so that the scale of the backlight modules increase with the growth of the liquid crystal display. Since the consumed electrical power of the backlight module is about 75% of the total consummation of the entire liquid crystal display, it is the component with the highest power consummation. Therefore, the performance of the backlight module is good or bad; it will directly affect the quality of liquid crystal displays. However, the disadvantages of the backlight module in the traditional liquid crystal display is that the brightness is not easily enhanced, lightweight and thinning tendency are not further finished, and high power consummation is also criticized.

The backlight module of light emitting diode is rapidly growth to solve the drawback existed in traditional backlight module Since the light emitting diode has the advantage of changing light intensity with breakneck speed, the local backlight brightness can be adjusted by the requirement of the local image brightness. The dynamic contrast ratio is much higher than the traditional cold cathode fluorescent lamps. Furthermore, the use of the light emitting diode backlight module can reduce the thickness, volume and weight of the display to effectively reach the requirements of lightweight and thinning tendency and to take into account the advantages of the environment protection, long life and low power consummation.

However, since the operating temperature of light emitting diode rose with time, and then the luminous efficacy decayed. Because that the light with different color in the light emitting diode has different recession rate. Furthermore, since the volume of the light emitting diode is small, the exit angle of the light is severely limited, so that the large amount of the light emitting diodes are required to meet the needs of the effective local image brightness, when they are installed in the liquid crystal display as the backlight module. It results in the increase of the power consumption, and the purpose of saving power cannot be effectively achieved.

### SUMMARY OF THE INVENTION

Therefore, a LED display device is developed herein to reach the requirements of lightweight and thinning tendency of the liquid crystal display, and to take into account the advantages of the environment protection, long life and low power consummation. A primary goal of the present invention is to provide a LED display device, especially to a liquid crystal display device which uses the light emitting diodes to combine with polymethylmethacrylate (PMMA) as a lighting module. The secondary lens theory composed of different refractive index between air and PMMA and the angle of the reflective layers on the inner surface of the side planes are used to effectively increase the refracted angle of light emitted from the light emitting diode and the distance of the mixed light and to effectively reach the advantages of thinner liquid crystal display and lower power consumption.

In order to achieve the above object, a LED display device includes a liquid crystal display, a shell, a plurality of lighting modules and two reflective layers. The liquid crystal display comprises a color filter component, a thin film transistor substrate and a liquid crystal layer, wherein the liquid crystal layer is disposed between the color filter component and the thin film transistor substrate. The shell correspondingly connects to the liquid crystal display, the shell comprises a back plane corresponded to the liquid crystal display and two side planes separately connects the back plane and the liquid crystal display, an optical traveling space is formed between the shell and the liquid crystal display. A plurality of lighting modules dispose in the back plane, every lighting module consists of a light emitting diode, a first refracting portion covering the light emitting diode and a second refracting portion covering the first refracting portion, wherein the first refracting portion and the second refraction portion separately have the refractive index N1 and N2, and N2 is larger than N1. Two reflective layers separately dispose on the side planes for reflecting the light emitted from the lighting modules to the liquid crystal display.

The first refracting portion is air, and the second refracting portion is consisted of polymethylmethacrylate (PMMA), its refractive index N2 is 1.49.

The second refracting portion has an arcuate top surface with inward sunken.

The reflective layer is made of a plurality of metal particles; the materials of the metal particles are selected from aluminum, copper, nickel, titanium, gold, silver or any combinations thereof.

Accordingly, the secondary lens theory and the angle of the reflective layers on the inner surface of the side planes are used to effectively reach the advantages of thinning tendency and lower power consumption of the liquid crystal display with light emitting diodes as the backlight module. In addition, the present invention uses the secondary lens theory of the lighting module composed of air and PMMA to increase the light refracted angle of light emitting diodes by different refractive index from the refracted rule, and to reduce the power consummation of backlight module and overall liquid crystal display to 30%. It also takes into account the environment protection requirement and the life of the liquid crystal display. Furthermore, the present invention uses the appearance of the PMMA with an arcuate top surface with inward sunken to effectively reach the advantage of increasing positive brightness and to maintain the light intensity of the light emitting diode to meet the requirement of the local image brightness. Final, the present invention adjusts the angle of the reflective layer in the side planes of the shell to reflect the light emitted from the light emitting diodes of the lighting modules to effectively reduce the distance of the mixed light, and then the overall thickness of the monitor is reduced up to 40% ∼ 70% to effectively reach the requirement of thinning tendency in overall liquid crystal display.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig.1 is a whole sectional drawing showing the structure of an embodiment of a LED display device according to the present invention;
Fig. 2 is a sectional drawing showing the structure of an embodiment of a lighting module according to the present invention;
Fig. 3 is a reflecting diagram showing the structure of an embodiment of a reflective layer according to the present invention.

### DETAILED DESCRIPTION OF THE PREFERRED EMBODIMENT

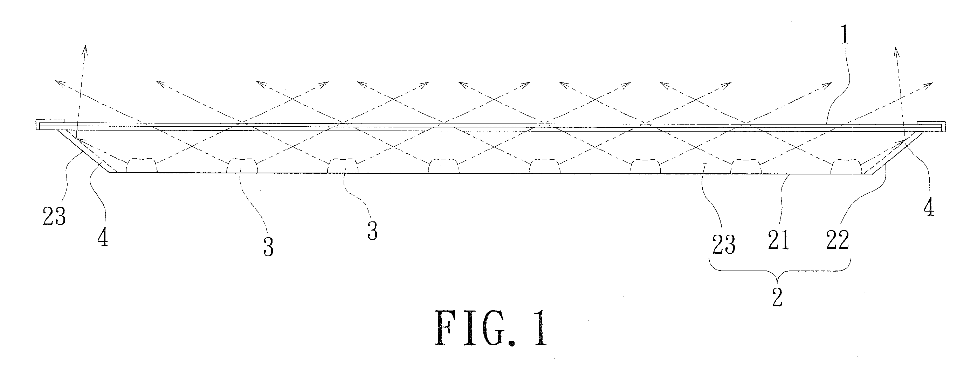

First, please refer to Fig. 1, it shows a structure of a LED display device according to the present invention, comprising,

A liquid crystal display (1) comprises a color filter component, a thin film transistor substrate and a liquid crystal layer, wherein the liquid crystal layer disposes between the color filter component and the thin film transistor substrate;

A shell (2) correspondingly connects to the liquid crystal display (1), the shell (2) comprises a back plane (21) corresponded to the liquid crystal display (1) and two side planes (22) separately connect to the back plane (21) and the liquid crystal display (1), an optical traveling space (23) is formed between the shell (2) and the liquid crystal display (1);

A plurality of lighting modules (3) dispose on the back plane (21), every lighting module (3) consists of a light emitting diode (31), a first refracting portion (32) which covers the light emitting diode (31) and a second refracting portion (33) which covers the first refracting portion (32), wherein the first refracting portion (32) and the second refraction portion (33) separately have the refractive indexes N1 and N2, and N2 is larger than N1; and

Two reflective layers (4) correspondingly dispose on the side planes (22) separately for reflecting the light emitted from the lighting modules (3) to the liquid crystal display (1).

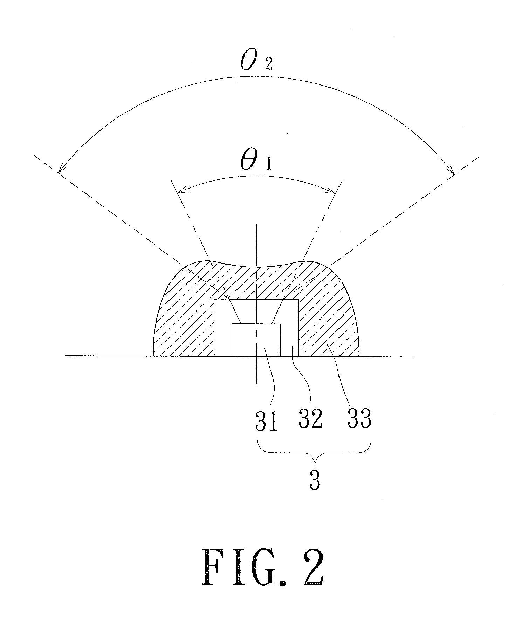

In addition, the first refracting portion (32) is air, and the second refracting portion (33) is consisted of polymethylmethacrylate (PMMA), wherein the refractive index N2 of PMMA 1.49 is larger than the refractive index 1 of air. As referring to Fig. 2, it shows a structure of a lighting module (3) according to the present invention, wherein the exit angle of the light emitted from the light emitting diode (31) to the first refracting portion (32) of air is θ1 degree, when the light passes through the interface between the second refracting portion (33) of PMMA and the first refracting portion (32) of air, it produces the first refraction, then the light continues to travel in the medium of PMMA, it finally passes through the interface between the second refracting portion (33) of PMMA and air to produce the second refraction and to drive the action of the liquid crystal in the liquid crystal display (1). According to the description of Snell's Law, when the light is transmitted from one medium to another medium with a different refractive index, the light occurs the phenomenon of refraction. Therefore, the refracted angle θ2 is larger than θ1 after the light is refracted by the second refracting portion (33) of PMMA. Since the light emitted from the light emitting diode (31) can be refracted a large angle by the second refracting portion (33) of PMMA to be a driving source of the liquid crystal display (1) and the overlapping portion of the light emitted from each of the light emitting diodes (31) increases, the used numbers of the light emitting diodes (31) as the backlight module in the traditional liquid crystal display (1) can be effectively reduced. Because the consumed electrical power of the backlight module is about 75% of the total consummation of the entire liquid crystal display, it is the component with the highest power consummation. Therefore, if the numbers of the light emitting diodes (31) as the lighting source of the backlight module can be effectively reduced, the power consummation of the backlight module will be easily reduced to reach the purpose of the low power consumption in the overall liquid crystal display. In the preferred embodiment of the present invention, the use of PMMA as the second refracting portion (33) which refracts the light from the light emitting diodes (31) can effectively reduce the power consummation of entire liquid crystal display and take into account the environment protection requirement with reducing carbon dioxide emissions. Furthermore, the polymethylmethacrylate (PMMA) is also known as acrylic or Plexiglas, and it is a polymeric and transparent material with the advantages of the high transparency, low cost and easy machining. Its transmittance is up to 92% higher than that of the general glass. It is an alternative material of glass in everyday life.

Furthermore, the second refracting portion (33) has an arcuate top surface with inward sunken. In the preferred embodiment of the present invention, as showing of Fig. 2, the second refracting portion (33) of PMMA which covered the first refracting portion (32) is directly above the light emitting diodes (31) and has an arcuate top surface with inward sunken. Since the second refracting portion (33) of PMMA directly above the light emitting diodes (31) has thinner thickness, the light emitted from the under light emitting diodes (31) has higher brightness to drive the liquid crystal materials and increase the display performance of the liquid crystal display (1).

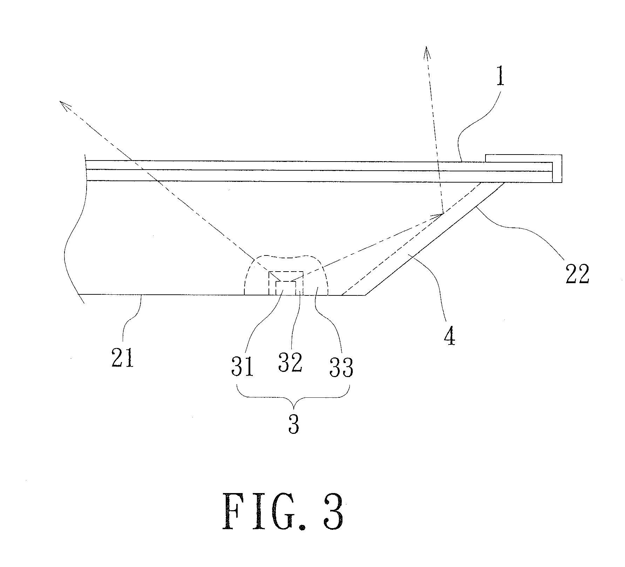

In addition, the reflective layer (4) is made of a plurality of metal particles, wherein the materials of the metal particles are selected from aluminum, copper, nickel, titanium, gold, silver or any combinations thereof. As referring to Fig. 3, it shows a reflected schematic diagram of a reflective layer (4) according to the present invention, wherein the reflective layers (4) are formed on the inner surface of the side planes (22) on the left and right of the optical traveling space (23). When the light emitted from the light emitting diodes (31) near the side planes (22) passes through the second refracting portion (33) of PMMA to enlarge the exit angle, some of light irradiated on the reflective layers (4) of the side planes (22). Since the reflective layer (4) is made of a plurality of metal particles, based on the principle of the reflected light by the metal particles, the light irradiated on the reflective layer (4) is reflected to the liquid crystal display (1). In the preferred embodiment of the present invention, the reflective layer (4) made of the metal particles can effectively reduce the distance of the mixed light, and then reach the thinning tendency of overall liquid crystal display.

Furthermore, according to the following preferred embodiment of the LED display device, the range of practical applications in the present invention can be further demonstrated, but the scope of the present invention is not limited by any ways. When the power of the LED display device is turned on, a plurality of light emitting diodes (31) disposed on the back plane (21) in the optical traveling space (23) starts to shine, the exit angle of the light emitted from the light emitting diode (31) to the first refracting portion (32) of air is θ1 degree, when the light passes through the interface between the second refracting portion (33) of PMMA and the first refracting portion (32) of air, it produces the first refraction, then the light continues to travel in the medium of PMMA, it finally passes through the interface between the second refracting portion (33) of PMMA and air to produce the second refraction, the refracted angle θ2 is larger than θ1. Finally the light arrive the liquid crystal display (1) to drive the action of the liquid crystal. Furthermore, the reflective layers (4) are formed on the inside surface of the side planes (22) on the left and right of the optical traveling space (23). When the light emitted from the light emitting diodes (31) near the side planes (22) passes through the second refracting portion (33) of PMMA to enlarge the exit angle, some of light irradiated on the reflective layers (4) of the side planes (22). Since the reflective layer (4) is made of a plurality of metal particles, based on the principle of the reflected light by the metal particles, the light irradiated on the reflective layer (4) is reflected to the liquid crystal display (1).

In summary, a LED display device according to the present invention has following advantages compared with techniques available now:
1. The secondary lens theory and the angle of the reflective layers on the inner surface of the side planes are used to effectively reach the advantages of thinning tendency and lower power consumption of the liquid crystal display with light emitting diodes as the backlight module.
2. The present invention uses the secondary lens theory of the lighting module composed of air and PMMA to increase the light refracted angle of light emitting diodes by different refractive index from the refracted rule, and to reduce the power consummation of backlight module and overall liquid crystal display to 30%. It also takes into account the environment protection requirement and the life of the liquid crystal display.
3. The present invention uses the appearance of the PMMA with an arcuate top surface with inward sunken to effectively reach the advantage of increasing positive brightness and to maintain the light intensity of the light emitting diode to meet the requirement of the local image brightness.
4. The present invention adjust the angle of the reflective layer in the side planes of the shell to reflect the light emitted from the light emitting diodes of the lighting modules to effectively reduce the distance of the mixed light, and then the overall thickness of the monitor is reduced up to 40% ∼ 70% to effectively reach the requirement of thinning tendency in overall liquid crystal display.

Additional advantages and modifications will readily occur to those skilled in the art. Therefore, the invention in its broader aspects is not limited to the specific details, and representative devices shown and described herein. Accordingly, various modifications may be made without departing from the spirit or scope of the general inventive concept as defined by the appended claims and their equivalents.

## Claims

1. A LED display device, comprising:
a liquid crystal display (1) comprising a color filter component, a thin film transistor substrate and a liquid crystal layer, wherein the liquid crystal layer disposing between the color filter component and the thin film transistor substrate;
a shell (2) correspondingly connecting to the liquid crystal display (1), the shell (2) comprising a back plane (21) corresponded to the liquid crystal display (1) and two side planes (22) separately connecting the back plane (21) and the liquid crystal display (1), an optical traveling space (23) is formed between the shell (2) and the liquid crystal display (1);
a plurality of lighting modules (3) disposing in the back plane (21), every lighting module (3) consisting of a light emitting diode (31), a first refracting portion (32) covering the light emitting diode (31) and a second refracting portion (33) covering the first refracting portion (32), wherein the first refracting portion (32) and the second refraction portion (33) separately having the refractive index N1 and N2, and N2 is larger than N 1; and
two reflective layers (4) separately disposing on the side planes (22) for reflecting the light emitted from the lighting modules (3) to the liquid crystal display (1).

2. The LED display device as claimed in claim 1, wherein the first refracting portion (32) is air, and the second refracting portion (33) is consisted of polymethylmethacrylate (PMMA), its refractive index N2 is 1.49.

3. The LED display device as claimed in claim 1, wherein the second refracting portion (33) has an arcuate top surface with inward sunken.

4. The LED display device as claimed in claim 2, wherein the second refracting portion (33) has an arcuate top surface with inward sunken.

5. The LED display device as claimed in claim 1, wherein the reflective layer (4) is made of a plurality of metal particles, the materials of the metal particles are selected from aluminum, copper, nickel, titanium, gold, silver or any combinations thereof.
